(19) Europäisches Patentamt
European Patent Office
Office européen des brevets

(11) **EP 4 446 458 A1**

(12) **EUROPEAN PATENT APPLICATION**

(43) Date of publication:
**16.10.2024 Bulletin 2024/42**

(21) Application number: **23167265.0**

(22) Date of filing: **11.04.2023**

(51) International Patent Classification (IPC):
**C23C 14/24** (2006.01)    **C23C 14/54** (2006.01)

(52) Cooperative Patent Classification (CPC):
**C23C 14/246; C23C 14/243; C23C 14/543**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **NEOVAC GmbH**
**63791 Karlstein (DE)**

(72) Inventors:
• **ENGLERT, Ulrich**
  **63791 Karlstein (DE)**
• **HERZOG, André**
  **63791 Karlstein (DE)**

(74) Representative: **Weilnau, Carsten et al**
**Patentanwälte Sturm Weilnau Franke Partnerschaft mbB**
**Unter den Eichen 5 (Haus C-Süd)**
**65195 Wiesbaden (DE)**

(54) **EVAPORATION UNIT**

(57) The present disclosure relate to an evaporation unit (10) for evaporating a metallic evaporation material, the evaporation unit (10) comprising:
- an evaporation crucible (40) inside an evaporation chamber (50),
- a melting crucible (20) outside the evaporation chamber (50) and fluidically connected with the evaporation crucible (40), the melting crucible (20) comprising a melting cavity (23) to melt the metallic evaporation material, to store and/or to heat molten evaporation material (12),
- a measuring arrangement (80) coupled to the melting crucible (20) and operable to quantitatively measure at least one of a fill level (28) of molten evaporation material (12) in the melting cavity (23) and a mass of molten evaporation material (12) in the melting crucible (20), the measuring unit (80) being further operable to generate a measurement signal being indicative of at least one of the fill level (28) and the mass of molten evaporation material (12),
- a controller (90) connected to the measuring arrangement (80) and operable to derive a fill level (48) of molten evaporation material (12) inside the evaporation crucible (40) on the basis of the measurement signal received from the measuring arrangement (80).

Fig. 8

**EP 4 446 458 A1**

Processed by Luminess, 75001 PARIS (FR)

## Description

The present invention relates to the field of coating substrates, and in particular to the field of coating metallic substrates with a metallic coating or anti-corrosive coating. In further aspects the present invention relates to an evaporation unit, a coating arrangement a method of determining a fill level of a molten evaporation material inside an evaporator.

## Background

Coating materials, such as a gaseous metal or metallic layers may be coated on a surface of a metallic substrate, such as a single sheet or steel strip. Here, the substrate is arranged in a coating- or vacuum atmosphere. In vacuum deposition there may be applied various deposition methods, by way of which a solid or liquid coating material, e.g. a metallic coating material, is evaporated. This typically implies a heating of the evaporation material up to an evaporation temperature, e.g. in a vacuum atmosphere, to transition into a gaseous or evaporated state. Once the evaporation material is sufficiently evaporated a thin-film is formed on the substrate as a coating.

Typically and for physical vapor deposition (PVD) of substrates on a rather large scale it is quite challenging to control a deposition rate of an evaporator located inside the vacuum atmosphere. Furthermore, it is quite challenging to provide a sufficient and/or constant supply of molten evaporation material to the evaporator and hence into the evaporation chamber.

For instance, document EP 3 812 481 A1 discloses an operation arrangement comprising a first and a second crucible that are fluidically connected. The first crucible can be arranged inside a vacuum chamber and the second crucible can be arranged outside the vacuum chamber. With this evaporation arrangement a fill level of the first crucible is controlled by controlling a gas pressure in the second crucible.

Modifying of a gas pressure in or with the second crucible outside the vacuum chamber is quite challenging and requires installation and precise controlling of respective equipment to provide a sufficient and precise fluid level control. In addition, the demand of modifying a gas pressure in the second crucible is detrimental to supply further material or evaporation material into the crucible without interrupting the coating process.

It is therefore desirable to provide improvements to an evaporation unit for evaporating a metallic evaporation or coating material, which improvements provide a rather easy and straightforward control of a fill level of molten evaporation material inside an evaporation crucible, which is arranged inside an evaporation chamber. It is also desirable to enable and/or to provide a rather easy and straightforward way of supplying evaporation or coating material to the respective crucible.

It is also quite challenging and demanding to precisely control a fill level of liquid molten evaporation material in an evaporation crucible or evaporator inside a vacuum chamber. The temperature inside the vacuum chamber may be in a range of more than 500°C thus making it difficult to have electrical or electronically operated sensors inside the vacuum chamber.

Moreover, transferring of electrical signals from inside the vacuum chamber to a controller located outside the vacuum chamber is quite difficult and demanding. Furthermore, fill level sensors arranged inside a vacuum chamber may be subject to continuous deposition of evaporation material as the evaporation unit is in use. Insofar, a sensor or sensing arrangement inside an evaporation chamber to determine or to measure a fill level of a molten material in an evaporator may either require regular maintenance or may exhibit only a limited lifetime.

It is therefore desirable to provide an improved evaporation unit that allows to precisely measure or to precisely determine a fill level of an evaporation material inside an evaporation crucible without making use of measuring equipment inside the evaporation chamber.

## Summary

The above-described problems and deficiencies are solved by an evaporation unit, a coating arrangement and a method of deriving or determining a fill level of a molten evaporation material in accordance to the features of the independent claims. Numerous examples and embodiments are subject matter of respective dependent claims.

In one aspect the present disclosure relates to an evaporation unit for evaporating a metallic evaporation material. The evaporation unit comprises an evaporation crucible inside an evaporation chamber. The evaporation unit further comprises a melting crucible outside the evaporation chamber. The melting crucible and the evaporation crucible are fluidically connected with each other. The melting crucible comprises a melting cavity to melt the metallic evaporation material, to store the metallic evaporation material and/or to heat the evaporation material. With some examples the evaporation crucible contains molten evaporation material. The molten evaporation material may be provided by a supply to the melting cavity either externally, e.g. by a separate melting unit or the evaporation material may be supplied in solid form, e.g. in granular form into the melting cavity. By way of example, the metallic evaporation material is molten inside the melting cavity. The melting crucible and the evaporation crucible are fluidically connected. Hence, the molten evaporation material may flow from the melting crucible towards and into the evaporation crucible through the fluidic connection.

Typically, the fluidic connection between the melting crucible and the evaporation crucible is a free-flowing fluid connection and simply connects the melting crucible with the evaporation crucible. By way of the fluidical connection between the evaporation crucible and the melting crucible a fluid level in the evaporation crucible may adapt a complementary or corresponding fluid level in the melting crucible; and vice versa.

The evaporation unit further comprises a measurement arrangement, which is coupled to the melting crucible. The measuring arrangement is operable to quantitatively measure at least one of a fill level of molten evaporation material in the melting cavity and a mass of molten evaporation material in the melting cavity or melting crucible. The measuring unit is further operable to generate a measurement signal being indicative of at least one of the fill level and the mass of molten evaporation material in the melting cavity or in the melting crucible.

The evaporation unit further comprises a controller connected to the measuring arrangement and operable to derive a fill level of molten evaporation material inside the evaporation crucible on the basis of the measurement signal received from the measuring arrangement.

In other words and due to the fluidical connection between the evaporation crucible and the melting crucible the fill level of molten evaporation material inside the evaporation crucible can be measured or derived indirectly, namely by quantitatively measuring at least one of a fill level of molten evaporation material in the melting cavity and a mass of molten evaporation material in the melting crucible.

When measuring a mass or weight of molten evaporation material in the melting crucible a fill level of the molten evaporation material in the melting cavity can be derived from the measured mass, when the geometric shape of the melting cavity is generally known and by taking further into account the temperature of the molten evaporation material and the density of the molten evaporation material at the given or measured temperature. In this way and by deriving the fill level of molten evaporation material in the evaporation crucible through quantitatively measuring a fill level or a mass of molten evaporation material in the melting cavity it can be effectively avoided to install or to use rather complicated or sensitive sensors or detectors inside the evaporation chamber, which during use of the evaporation unit would be subject to contamination.

In addition, quantitatively measuring at least one of the mass and the fill level of the molten evaporation material in the melting crucible is rather easy to realize by using comparatively simple sensors, sensor elements or measurement devices. With a quantitative measurement of at least one of the fill level and the mass of the molten evaporation material outside the vacuum chamber there can be provided a rather constant or permanent and hence rather precise fill level determination of molten material inside the melting crucible as well as inside the evaporation crucible.

In this way there can be provided a rather precise and continuous fill level monitoring of the melting crucible and the evaporation crucible, which allows for a rather precise and immediate control of the entire evaporation or coating process.

According to a further example the measuring arrangement comprises at least one of a pressure sensor and a temperature sensor. The pressure sensor is operable to measure at least one of an environmental pressure inside the melting cavity and a vacuum pressure inside the evaporation chamber. The temperature sensor is operable to measure a temperature of the molten evaporation material at least inside one of the melting cavity and the evaporation crucible. In some examples the evaporation unit comprises two pressure sensors, one of which being arranged inside the evaporation chamber and operable to measure a vacuum pressure inside the evaporation chamber. The further pressure sensor is typically located outside the evaporation chamber. It may be operable to measure atmospheric pressure or environmental pressure in the environment of the melting crucible.

In addition or alternatively, the vacuum pressure inside the evaporation chamber may be also obtained from a vacuum pump coupled with the evaporation chamber and operable to establish a respective low pressure or a vacuum condition inside the evaporation chamber. Insofar, a respective pressure sensor operable to provide a vacuum pressure inside the evaporation chamber may be also arranged outside the evaporation chamber but may be in a gas flow communication with the inside of the evaporation chamber.

In some examples the evaporation unit may be also provided with at least two temperature sensors, wherein a first temperature sensor is operable to measure a temperature of the molten evaporation material inside the melting crucible or melting cavity. A further, and hence a second temperature sensor may be operable to measure a temperature of the molten evaporation material inside the evaporation crucible or evaporator.

By measuring at least one of the environmental pressure and the vacuum pressure a pressure difference between the melting crucible and the evaporation crucible can be derived, which is further taken into account by the controller for deriving the fill level of molten evaporation material inside the evaporation crucible. In the same way, also the temperature of the molten evaporation material inside the melting crucible and/or inside the evaporation crucible can be taken into account.

Knowledge of a pressure difference between the environment of the evaporation crucible and the environment of the melting crucible allows to precisely determine or to precisely derive the fill level of molten evaporation material inside the evaporation crucible on the basis of at least one of the fill level of molten evaporation material in the melting cavity and the mass of molten evaporation material in the melting crucible.

In a further example the controller of the evaporation unit is operable to derive the fill level of molten evaporation material inside the evaporation crucible by taking further into account at least one of the environmental pressure inside or around the melting cavity, the vacuum pressure inside the evaporation chamber, the temperature of the molten evaporation material inside the cavity and the temperature of the molten evaporation material inside the evaporation crucible.

In further examples it is also conceivable to measure a temperature of the molten evaporation material inside or along a fluid connection, e.g. a fluid pipe extending between and fluidically coupled with the evaporation crucible and the melting crucible.

Furthermore, and by taking into account the temperature of the molten evaporation material the temperature dependency of the density of the evaporation material can be precisely taken into account for determining a fill level of the molten evaporation material inside the melting crucible and/or inside the evaporation crucible on the basis of a measured mass of the evaporation material.

Due to the fluidic connection between the melting crucible and the evaporation crucible the fill level of molten evaporation material inside the melting crucible and inside the evaporation crucible is subject to a common hydrostatic pressure. The hypostatic pressure p is defined by the product of the gravitation constant $g$, the density of the material $\rho$ and the height of the fluid level of the evaporation material inside the respective crucible as : $\rho = \rho\, g\, h$.

If the melting crucible and the evaporation crucible are subject to different surrounding pressures, the respective pressure difference leads to respective modification of the fill level of the molten evaporation material in the respective crucible. Moreover, and when e.g. the melting crucible is exposed to atmospheric pressure also the influence of the atmospheric pressure has to be taken into account when calculating e.g. a hydrostatic pressure of the melting crucible.

Presumed that the evaporation crucible and the melting crucible would be exposed to identical environmental pressure and presumed that the evaporation crucible and the melting crucible would be arranged at a common level the height of the fill level of the molten evaporation material in the evaporation crucible would be identical to the respective fill level of evaporation material in the melting crucible. Now and when arranging the evaporation crucible inside the evaporation chamber and when starting to evacuate the evaporation chamber the pressure in the vicinity of the evaporation crucible is reduced, which leads to a rise of the fill level of molten evaporation material in the evaporation crucible. An environmental or surrounding pressure difference between the evaporation crucible and melting crucible can be easily compensated by arranging the evaporation crucible at a level, which is higher than the level of the melting crucible. This allows to withdraw molten evaporation material from the melting crucible in vertical direction by suction and hence against the action of gravity.

The difference in height of the position of the evaporation crucible relative to the melting crucible can be compensated by a difference in the surrounding pressure of the evaporation crucible and the melting crucible.

Typically, and in some examples the position of the evaporation crucible inside the evaporation chamber is fixed. It is at least fixed with regards to a vertical direction.

In a further example the evaporation unit comprises a liquid level adjuster coupled with the melting crucible and operable to vary a level of the molten evaporation material inside the melting cavity with respect to a ground and/or with respect to a sidewall of the melting crucible or melting cavity. By varying the absolute liquid level of the molten evaporation material relative to ground and/or relative to the sidewall of the melting crucible also the liquid level of the molten evaporation material inside the evaporation crucible can be changed and modified accordingly. A rise in the liquid level of molten material in the melting crucible equally transfers into a respective modification of the liquid level of molten evaporation material in the evaporation crucible.

Furthermore, and with the controller, it is also possible to take into account the temperature dependency of the density of the molten evaporation material, when e.g. the temperature of the molten evaporation material in the evaporation crucible should be higher than the temperature of the molten evaporation material in the melting crucible.

Typically, the liquid level adjuster provides a direct and absolute modification or adjustment of a liquid level of the molten evaporation material inside the melting cavity, which due to the fluidical connection with the evaporation crucible then equally reflects also in a respective modification of the liquid level of molten evaporation material inside the evaporation crucible.

According to a further example a fill level of molten evaporation material inside the evaporation crucible is adjustable by varying the level or height of the molten evaporation material in the melting crucible. For this, either the liquid level of the molten evaporation material inside the melting crucible can be varied relative to the melting crucible or sidewall of the melting crucible. Alternatively or additionally, the position of the entire melting crucible can be varied with regard to the vertical direction. Hence, a height of the melting crucible and hence a respective height of the liquid level of the molten evaporation material stored or contained therein can be modified in this way. In either way, a modification of the liquid level of the molten evaporation material inside the melting crucible can be used to control and/or to modify the liquid level or fill level of the molten evaporation material inside the evaporation crucible.

According to a further example the liquid level adjuster is coupled to the controller. The controller is operable to control operation of the liquid level adjuster in order to keep the fill level of molten evaporation material inside the evaporation crucible in a predefined range. Insofar, the measuring arrangement, the controller and the liquid level adjuster form or constitute a control loop by way of which the fill level of molten evaporation material inside the evaporation crucible can be kept within a predefined range.

The measuring arrangement provides a quantitative measurement or determination of the momentary fill level of molten evaporation material inside the evaporation crucible. Should it be detected that the fill level of molten evaporation material in the evaporation crucible is subject to a significant change the controller may be operable to adjust the fill level of the evaporation crucible by a respective control action of the liquid level adjuster. In a typical scenario of use, namely when a significant amount of molten evaporation material is evaporated the in or from the evaporation crucible, e.g. for coating the substrate, the amount of molten evaporation material inside the evaporation crucible may constantly drop. This loss of molten evaporation material in the evaporation crucible is compensated by the fluidical coupling or fluidic connection with the melting crucible, by way of which molten evaporation material is constantly supplied to and into the evaporation crucible.

For instance, and should the controller determine that the liquid level or fill level of the evaporation crucible drops below a minimum fill level the control is operable to control the liquid level adjuster accordingly so as to raise the liquid level of molten evaporation material in the melting crucible, thereby also raising the liquid level of the molten material in the evaporation crucible through the fluidical connection between the melting crucible and the evaporation crucible.

Also and in the other way, if for instance the controller should detect or determine that the fill level of the molten material inside the evaporation crucible exceeds or tends to exceed a maximum fill level the liquid level adjuster may be controlled accordingly so as to reduce the liquid level or fill level of the molten evaporation material of the melting crucible, thereby immediately also reducing the liquid level or fill level of an evaporation material in the evaporation crucible.

According to a further example the liquid level adjuster comprises a lifting device supporting the melting crucible and being operable to modify and/or to adjust a height of the melting crucible relative to the ground. The lifting device may comprise a drive and a kind of a lifting arrangement, such as a scissor lift. The lifting device is electrically controllable by the drive and serves to raise or to lower the vertical position of the melting crucible. In this way, the absolute or total height of the liquid level of the molten evaporation material inside the melting crucible and/or relative to ground can be effectively varied.

According to a further example the liquid level adjuster comprises a displacement body variably immersible into the molten evaporation material inside the melting crucible to thereby vary a liquid level or fill of the molten evaporation material inside the melting cavity with respect to the sidewall of the evaporation crucible or relative to the sidewall of the melting cavity. The displacement body may comprise a solid body, e.g. made of a temperature resistant material. The displacement body is typically made of a material that comprises a melting point that is higher than the melting point of the evaporation material. Hence, the displacement body is at least partially or completely immersible into the molten evaporation material thereby inducing a rise of the liquid level of molten evaporation material inside the melting crucible or melting cavity.

The displacement body may be connected or mechanically coupled with an electrical drive, which electrical drive is controllable by the controller of the evaporation unit. The drive may be implemented as a servo drive and may be connected to the displacement body through a connector, such as a rod or chain. The displacement body may be arranged above the melting crucible. The material of the displacement body may comprise a volumetric mass density, which is higher than the respective density of the evaporation material. In this way, the displacement body tends to immerse or to submerge into the molten evaporation material under the effect of gravity.

Implementations of a liquid level adjuster with a displacement body may be preferred in examples or embodiments of the evaporation unit, wherein the total weight of the melting crucible is comparatively large.

In some examples, the volume of the melting crucible is larger than the volume of the evaporation crucible. In some examples the volume of the melting crucible, and hence the volume of the melting cavity is twice as large as the volume of the evaporation crucible. In some examples, the volume of the melting cavity is at least three times, at least four times, at least five times as large as the volume of an evaporation cavity of the evaporation crucible. In this way, the melting crucible can be also used as a storage crucible operable to store and/or to provide a comparatively large amount of molten evaporation material, which upon demand and depending on the evaporation rate at which molten evaporation material transitions into the gas phase and hence into an evaporated state with the evaporation crucible, can be supplied to the evaporation crucible.

With a comparatively large volume the melting crucible can be also used to melt evaporation material that is supplied in solid form at a comparatively low temperature into the molten evaporation material already stored inside the melting cavity. With a comparatively large volume of the melting cavity, adding or supplying of non-molten and rather solid evaporation material into the molten evaporation material has only a little or small effect on a pressure variation of the molten evaporation material inside the melting cavity.

According to a further example the melting crucible and the evaporation crucible are fluidically connected via a heated fluid connection. By way of a heated fluid connection it can be prevented that the molten evaporation material experiences a cooling effect when transported between the melting crucible and the evaporation crucible. Moreover, by way of the heated fluid connection the evaporation material may be even subject to a constant heating and optionally also of a rise in temperature as it flows from the melting crucible towards and into the evaporation crucible.

With some examples the heated fluid connection may enter the melting crucible from above. The heated fluid connection may comprise a first end section terminating inside the melting crucible, e.g. inside the melting cavity. It may extend into the melting cavity and hence into the melting crucible from above and may be oriented in a vertical manner. This allows for a rather easy and straightforward lifting and lowering of the melting crucible, e.g. by the liquid level adjuster and/or its lifting device as described above. A substantially vertically oriented section of the fluid connection facing towards downwards and into the melting crucible is of particular benefit to modify the height or vertical position of the melting crucible while keeping the fluid connection fixed. Here, a variation of the height of the melting crucible only varies a depth of immersion of the end section of the fluid connection into the molten evaporation material inside the melting cavity.

In other examples the end section of the heated fluid connection facing towards or coupled with the melting crucible extends into and through a sidewall of the melting crucible near a bottom of the melting crucible. Here and when the melting crucible should be mounted on a lifting device and should be subject to a variation of the vertical position the heated fluid connection may comprise at least one flexible portion to adapt to the change in height or position of the melting crucible.

According to a further example the evaporation unit also comprises a feeding unit operable to supply solid or molten evaporation material into the melting crucible. The feeding unit may be arranged above the melting crucible and may be operable to supply evaporation material into the melting crucible from above. The feeding unit may provide a controllable supply of evaporation material into the melting crucible. In some examples and when the evaporation material is provided in solid form of a metal wire, the feeding unit may be operable to feed the metal wire e.g. at a constant or adjustable rate into the molten evaporation material inside the melting crucible. In other examples and when the evaporation material is provided in a granular form the feeding unit may be operable to supply a respective rate of granular material into the molten evaporation material inside the melting crucible.

In other examples and when the evaporation material is provided in form of ingots the feeding unit may be configured to slowly introduce a rather large block of solid evaporation material into the molten material inside the melting cavity.

Typically and according to a further example the feeding unit is coupled to the controller and the controller is operable to control operation of the feeding unit thereby also controlling a supply of solid or molten evaporation material into the melting crucible. Typically, the controller may be operable to maintain a constant fluid level of molten evaporation material inside the melting crucible during the process of feeding or melting solid evaporation material into the melting crucible or melting cavity.

Particularly and when the evaporation material is e.g. provided as a solid ingot lowering the respective evaporation material into the molten of evaporation material may be combined with an eventual lowering of the vertical position of the melting crucible in order to keep the liquid level of the molten evaporation material relative to ground rather constant. In this way, the liquid level and hence the fill level of molten evaporation material inside the evaporation crucible can remain effectively constant and may not be influenced by the supply of solid or molten evaporation material into the melting crucible.

According to a further example the melting crucible is exposed to atmospheric pressure. Hence, the melting crucible is not only arranged outside the evaporation chamber but is also exposed to atmospheric pressure. Arranging the melting crucible outside the evaporation chamber and also outside any gas tight enclosure is of particular benefit to supply solid or molten evaporation material into the melting crucible during the ongoing evaporation and coating process inside the evaporation chamber. Nonetheless and when exposed to atmospheric pressure the respective atmospheric pressure has to be taken into account by the controller to correctly derive a fill level of molten evaporation material in the evaporation crucible. Any natural modifications or fluctuations of the atmospheric pressure can and have to be taken into account when calculating or deriving the fill level of molten evaporation material in the evaporation crucible, e. g. on the basis of the fill level of the molten evaporation material in the melting crucible.

In another example of the evaporation unit the measuring arrangement comprises at least one of a fill level sensor and a scale coupled to the melting crucible. The fill level sensor is operable to measure the fill level of evaporation material inside the crucible. The scale is operable to measure at least one of a weight of the melting crucible and the molten evaporation material inside the melting crucible. The fill level sensor is operable to quantitatively measure the fill level of molten evaporation material. The fill level sensor may be implemented as a contactless fill level sensor. The fill level sensor may comprise an optical sensor by way of which a distance to the surface of the liquid level of the molten evaporation material inside the melting crucible can be precisely determined or quantitatively measured.

The fill level sensor may be attached to the melting crucible, e.g. to a housing of the melting crucible. Here, the fill level sensor may be fixed to the melting crucible and may be thus operable to measure a liquid level of the molten evaporation material inside the melting crucible e.g. relative to a reference of the melting crucible. In this example and when the melting crucible should be subject to a lifting operation, e.g. by a lifting device of the liquid level adjuster, a respective level adjustment provided by the liquid level adjuster or lifting device has to be further taken into account in addition to the liquid level as quantitatively measured by the fill level sensor.

In another example the fill level sensor may be arranged stationary and may face towards the surface of the liquid level of the molten evaporation material inside the melting crucible, e.g. from above. Here and with a fill level sensor stationary fixed relative to ground, the liquid level of the motion of evaporation material relative to ground can be precisely determined and/or quantitatively measured.

In some examples the fill level sensor comprises a laser light source and a respective detector. The fill level sensor may comprise a laser-based distance measuring device by way of which the distance or position of the liquid level or surface of the molten evaporation material inside the melting crucible can be quantitatively measured and/or determined.

With a scale operable to measure at least one of a weight of the melting crucible and/or of evaporation material inside the melting crucible, there is provided an alternative way of how to determine the fill level of molten evaporation material inside the melting cavity. Here, the temperature of the molten evaporation material inside the melting crucible also has to be determined in order to derive the fill level of the molten evaporation material inside the melting crucible on the basis of the weight or mass measurement.

In some examples the measuring arrangement comprises both, a fill level sensor and a scale. In some examples, the fill level sensor provides the measurement signal on the basis of which the controller derives the fill level of molten evaporation material inside the evaporation crucible. Here, measurement signals obtainable from the scale can be used as a backup signal and may thus provide a redundant measurement in case that the measurement provided by the fill level sensors should be subject to a failure. Vice versa, also the measurement signal generated by the scale could be used as the measurement signal processed by the controller to derive the fill level of molten evaporation material inside the evaporation crucible. Then, the signals as obtained from the fill level sensor may be used as a backup signal.

In some examples, signals of both, the fill sensor and the scale may be processed simultaneously by the controller in order to determine if the measuring arrangement works correctly. If any of the signals obtainable from the scale and from the fill level sensor should deviate from each other at least one of the fill level sensor and the scale are subject to malfunction. The controller may then generate an alarm and/or may switch the evaporation unit into an emergency mode.

In another aspect the present disclosure also relates to a coating arrangement for coating a substrate with a metallic material through vapor deposition, e.g. physical vapor deposition. The coating arrangement comprises an evaporation chamber to receive the substrate and further comprises an evaporation unit as described above. The evaporation unit comprises an evaporation crucible arranged inside the evaporation chamber. The melting crucible of the evaporation unit is arranged outside the evaporation chamber of the coating arrangement. It may be exposed to atmospheric pressure, which facilitates supply of evaporation material into the melting crucible during a coating process.

In some examples the evaporation chamber is a vacuum chamber. It is coupled with a vacuum pump by way of which a vacuum and hence a vacuum pressure can be generated inside the evaporation chamber. The evaporation crucible is also subject to the vacuum pressure inside the evaporation chamber. The evaporation crucible is fluidically connected to the melting crucible. It may be arranged at a higher level compared to the melting crucible. Since the evaporation crucible is exposed to a vacuum pressure and since the melting crucible may be exposed to atmospheric pressure, the evaporation crucible inside the evaporation chamber may be arranged at a level substantially higher than the melting crucible outside the evaporation chamber. The difference in pressure may directly reflect in a difference in height or vertical level between the liquid level of molten evaporation material inside the melting crucible and a liquid level of molten evaporation material inside the evaporation crucible.

Arranging of the evaporation crucible above the melting crucible is also of particular benefit in case that the evaporation crucible and/or the evaporation chamber to become subject to maintenance. Emptying of the evaporation crucible may be exclusively obtained under the effect of gravity, whereby the molten evaporation material located inside the evaporation crucible simply flows through the fluidical connection back into the melting crucible.

In some examples the substrate comprises a sheet of steel or metal. In other examples the substrate comprises a continuous strip or band of metal or steel to be coated with a metallic or metallic alloy evaporation material comprising at least one or a combination of the following materials: zinc, aluminum, nickel, chrome, magnesium or titanium.

In some examples the coating arrangement is configured to coat a surface of the substrate with an anti-corrosive layer or anti-corrosive coating. In some examples, the vacuum coating system is configured for coating a band-type metallic substrate, such as a steel, with a metallic material or metallic alloy comprising at least one or a combination of at least one or more of the following materials: zinc, aluminum, nickel, chrome, magnesium or titanium, e.g. by way of physical vapor deposition (PVD).

Since the coating arrangement comprises an evaporation unit as described above, all features, effects and benefits as described above in connection with the evaporation unit equally apply to the coating arrangement; vice versa.

In a further aspect the present disclosure also relates to a method of deriving or determining a fill level of molten evaporation material inside an evaporation crucible, which evaporation crucible is located inside an evaporation chamber, e.g. of a coating arrangement as described above. The evaporation crucible is fluidically connected with a melting crucible. The melting crucible is located outside the evaporation chamber. The melting crucible is configured to melt the metallic evaporation material, to store and/or to heat molten evaporation material. The method comprises the step of quantitatively measuring at least one of a fill level and a mass of molten evaporation material inside the melting crucible outside the evaporation chamber and deriving or determining the fill level of molten evaporation material inside the evaporation crucible on the basis of at least one of the fill level and the mass of molten evaporation material inside the melting crucible.

In some examples deriving or determining the fill level of molten evaporation material further takes into account at least one of an environmental pressure inside or around the melting cavity, a vacuum pressure inside the evaporation chamber, a temperature of the molten evaporation material inside the melting cavity and the temperature of the molten evaporation material inside the evaporation crucible.

Typically, the method of deriving or determining a fill level of molten evaporation material inside the evaporation crucible is conducted or executed with an evaporation unit and/or with a coating arrangement as described above. Insofar, all features, effects and benefits as described above in connection with the evaporation unit and the coating arrangement equally apply to the method of deriving or determining the fill level of molten evaporation material; and vice versa.

According to a further example the method further includes the step of controlling or modifying the fill level of molten evaporation material inside the evaporation crucible by varying a level of molten evaporation material inside the melting crucible and hence inside a melting cavity of the melting crucible with respect to a ground and/or with respect to a sidewall of the melting crucible. In some examples the method may provide or constitute a control mechanism by way of which the liquid level and hence the fill level of molten evaporation material in the evaporation crucible can be kept in a predefined range. Eventual modifications, e.g. a rise and fall of the liquid level of the molten evaporation material in the evaporation crucible can be indirectly measured and a by way of a liquid level adjuster coupled with the melting crucible, a fill level of the melting crucible and hence a respective fill level of the evaporation crucible can be adjusted accordingly so as to keep the liquid level or fill level of the molten evaporation material in the evaporation crucible in a desired or predefined range.

Brief Description of the Drawings

In the following, numerous examples of the evaporation unit, the coating arrangement and a method of deriving or determining a fill level of molten evaporation material are described in greater detail by making reference to the drawings, in which:

Fig. 1    schematically illustrates a coating arrangement with an evaporation unit,

Fig. 2    schematically shows a further example of an evaporation unit,

Fig. 3    schematically shows a further example of an evaporation unit,

Fig. 4    schematically shows details of an example of the melting crucible,

Fig. 5    shows an example of an evaporation crucible,

Fig. 6    shows another example of an evaporation crucible,

Fig. 7    shows a further example of an evaporation crucible,

Fig. 8    shows a block diagram of the evaporation unit and coating arrangement,

Fig. 9    schematically illustrates a three-dimensional view of a portion of an evaporation crucible according to Fig. 5,

Fig. 10    is a flowchart of a method of deriving or determining a fill level of molten evaporation material and

Fig. 11    is a flowchart of a method of adjusting or controlling an evaporation rate of an evaporation unit.

Detailed description

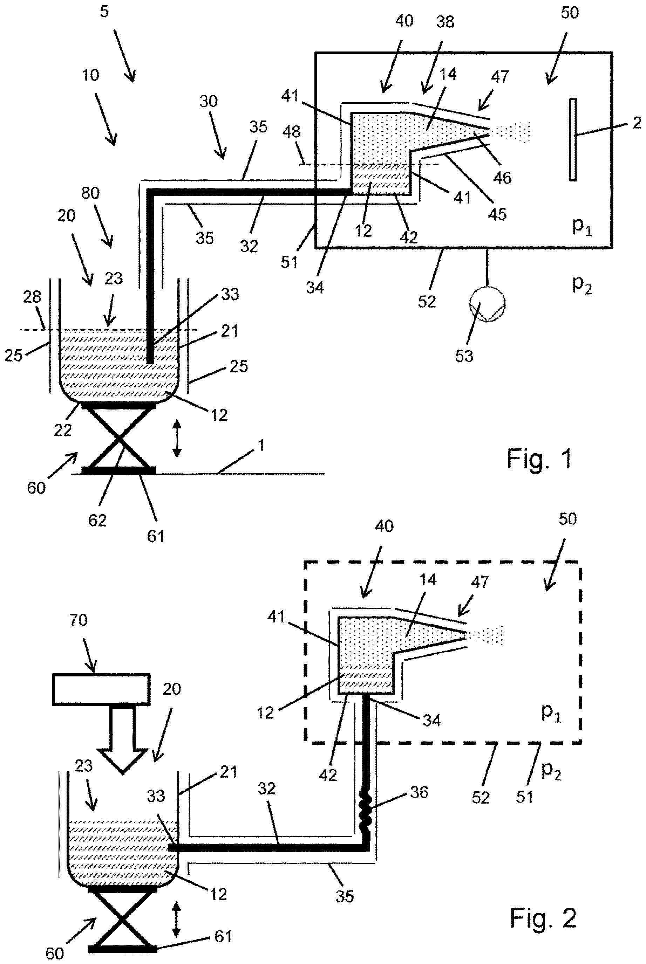

In Figs. 1-9 there are illustrated numerous examples of a coating arrangement 5 comprising an evaporation unit 10. The coating arrangement 5 may be implemented to coat a metallic substrate with a metallic material. The coating arrangement 5 may be particularly configured to coat strips or sheets of steel with an anti-corrosive coating, e.g. comprising at least one or a combination of the following materials: zinc, aluminum, nickel, chrome, magnesium or titanium.

The coating arrangement 5 is configured to evaporate a molten evaporation material 12 and to generate evaporated material 14, which is applied to the surface of the substrate 2. The coating arrangement 5 is configured to coat the substrate 2 via vapor deposition, in particular via physical vapor deposition.

The coating arrangement 5 comprises an evaporation unit 10. The evaporation unit 10 comprises an evaporation crucible 40 inside the evaporation chamber 50. The evaporation unit 10 further comprises a melting crucible 20 outside the evaporation chamber 50 and fluidically connected with the evaporation crucible 40. The fluidic connection between the melting crucible 20 and the evaporation crucible 40 is provided by a fluid connection 30. The fluid connection 30 comprises a fluid guiding pipe 32, which is provided with a heating 35. The fluid connection 30 comprises an end section 33, which is immersed in molten evaporation material 12 provided or stored in the melting crucible 20. The fluid connection 30 and hence the pipe 32 comprises an opposite longitudinal end section 34, which is fluidically connected with the evaporation crucible 40.

By way of the fluid connection 30 the melting crucible 20 and the evaporation crucible 40 are permanently in fluid connection. Hence, a fill level 48 of the molten evaporation material 12 inside a melting cavity 23 of the melting crucible 20 always corresponds and/or correlates to a respective fill level 48 of molten of evaporation material 12 inside the evaporation crucible 40.

For melting of the evaporation material inside the melting cavity 23 and/or for storing molten evaporation material 12 inside the melting cavity 23 the melting crucible 20 is provided with a heating 25. The end section 33 of the fluid connection 30 is immersed into the molten evaporation material 12. This way, any impurities of the molten ever evaporation material 12 aggregating at a surface of the molten material 12 will be effectively hindered from entering the end section 33.

The evaporation crucible 40, which is located inside the evaporation chamber 50 is exposed to a reduced pressure, e.g. to a pressure at vacuum level. Particularly, the melting crucible 20 may be exposed to atmospheric pressure P2. The evaporation crucible 40 inside the evaporation chamber 50 is subject to a vacuum pressure p1. The evaporation crucible 40 is also provided with a heating 45 by way of which the molten evaporation material 12 in the evaporation crucible 40 can be heated to such an extent that a significant amount thereof transitions into evaporated material 14 and hence transitions into the gaseous phase. The gaseous evaporated material 14 may exit the evaporation crucible 40 through an outlet 46, which may be provided with a nozzle section 47 by way of which a jet or accelerated stream of evaporated material 14 impinges on the surface of the substrate 2.

The inside of the evaporation chamber 50 is coupled with a vacuum 53. The evaporation chamber 50 comprises a chamber wall 51 and forms or constitutes a vacuum chamber 52.

The fluid connection 30 extends through the chamber wall 51 and provides a permanent fluid communication between the evaporation crucible 40 and the melting crucible 20.

In some examples the melting crucible 20 serves to melt solid evaporation material, which may be supplied by a feeding unit 70 as indicated in Fig. 2. This way, there can be provided a constant supply of molten evaporation material 12 to the melting crucible 20 and hence to the evaporation crucible 40. It is of particular benefit, when the melting crucible 20 is located outside the evaporation chamber 50 and hence outside the vacuum chamber 52. It may be provided in a non-encapsulated configuration. It may be permanently exposed to atmospheric pressure. This provides a rather easy and straightforward supply of evaporation material to the melting crucible 20.

Due to the permanent fluid connection between the melting crucible 20 and the evaporation crucible 40 the fluid level or fill level 48 inside the evaporation crucible 40 can be adjusted by correspondingly adjusting the fill level 28 of molten evaporation material 12 in the melting crucible 20. Moreover, and since the pressure p1 is lower than the pressure p2 the melting crucible 20 may be located at a height below the evaporation crucible 40. A difference in height $\Delta h$ may be easily compensated by the pressure difference according to the following formula:

$$\Delta h = \left| \frac{p_1 - p_2}{\rho\, g} \right|$$

,with g being the gravitational acceleration and $\rho$ as the density of the molten evaporation material 12.

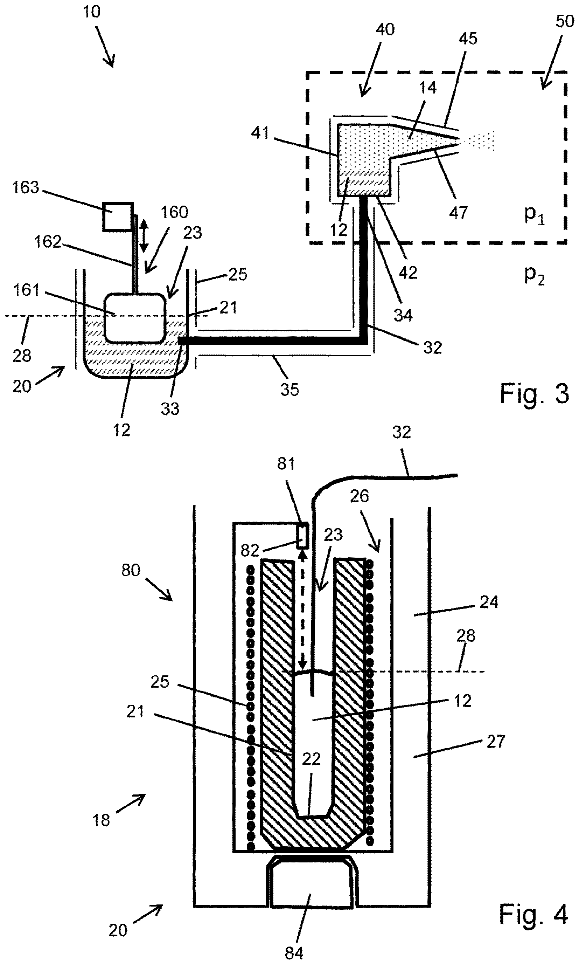

For regulating or controlling the fill level 48 inside the evaporation crucible 40 the fill level 28 of the molten evaporation material 12 inside the melting crucible 20 is measured and adjusted. This can be provided by a liquid level adjuster 60 as illustrated in Figs. 1 and 2 or by a liquid level adjuster 160 as illustrated in Fig. 3. The liquid level adjuster 60 comprises a lifting device 61, by way of which the height or vertical position of the entire melting crucible 20 can be varied or adjusted. In the illustrated example the liquid level adjuster 60 comprises a scissor lift 62, which is controllable by a controller 90. Of course, this scissor lift 62 is operable by an electrical drive, which is operated or controlled by the controller 90. By raising or lowering the lifting device 61, the vertical position of the entire melting crucible 20 can be varied relative to a ground 1.

Accordingly, and by raising or lowering the melting crucible 20 the fill level 28 of the molten evaporation material 12 relative to the ground 1 can be varied and adjusted. Since the evaporation crucible 40 is fixed inside the evaporation chamber 50 a respective rise or lowering of the fill level 28 of molten evaporation material 12 in the melting crucible 20 has a respective effect on the fill level 48 of molten evaporation material 12 inside the evaporation crucible 40.

In Fig. 3 there is illustrated another example of a liquid level adjuster 160. Here, the liquid level adjuster 160 comprises a displacement body 161, which is configured to be immersed into the molten evaporation material 12 of the melting crucible 20. The liquid level adjuster 160 comprises a drive 163, which is also operable or controllable by the controller 90. The drive 163 is connected with the displacement body 161 through a connector 162. The connector 162 may comprise at least one of a rod and a chain. The displacement body may be a solid body made of a material, which comprises a melting temperature, which is above the melting temperature of the evaporation material 12 inside the melting cavity 23.

Moreover, the material of the displacement body 161 may comprise a higher density compared to the density of the molten evaporation material 12. This way, the displacement body 161 may easily immerse or submerge into the molten evaporation material 12 under the effect of gravity.

By way of lowering or immersing the displacement body 161 into the molten evaporation material 12 the fill level 28 of the molten material 12 relative to a sidewall 21 of the melting cavity 23 can be increased, which leads to a respective modification and/or adjustment of the fill level 48 of molten evaporation material 12 inside the evaporation crucible 40.

With the example of Fig. 1 the melting crucible 20 is open towards the top and the fluid connection 30 with the pipe 32 extends into the molten evaporation material 12 from above. Here and by raising or lowering the melting crucible 20 with the lifting device 61 only the immersion depth of the end section 33 of the pipe 32 is varied.

With the alternative examples as shown in Figs. 2 and 3 the pipe 32 extends through a lower portion of the sidewall 21 of the melting cavity 23 and the end section 33 of the pipe 32 may extend through the side wall 21 near a bottom 22 of the melting cavity 23.

In the example of Fig. 2 and with a liquid level adjuster 60 comprising a lifting device 61 the pipe 32 may comprise a flexible portion 36 in order to compensate varying heights between the oppositely located end sections 33 and 34 of the pipe 32. With the example of Fig. 2, the end section 43 of the pipe 32 extends through a bottom 42 of the evaporation crucible 40. In the example of Fig. 1 the end section 34 extends through a lower portion of a sidewall 41 of the evaporation crucible 40 adjacent, near or close to the bottom 42. The example of a liquid level adjuster 160 according to Fig. 3 may be beneficial for such examples of the coating arrangement 5 or evaporation unit 10, where the melting crucible 20 comprises a significant mass or weight.

The evaporation unit 10 further comprises a measuring arrangement 80[AR1] which is coupled to the melting crucible 20 and which is operable to quantitatively measure at least one of a fill level 28 of molten evaporation material 12 in the melting cavity 23 and a mass of molten evaporation material 12 in the melting crucible 20 or melting cavity 23. For this, the measuring arrangement 80 comprises at least one of a liquid level detector 81 and a scale 84 as illustrated in Fig. 4.

In Fig. 4 there is shown a melting unit 18 comprising the melting crucible 20. The melting unit 18 comprises a carrier 24 or chassis comprising or forming a receptacle 26 sized to receive or to accommodate the melting crucible 20. Inside the receptacle 26 the melting crucible 20 is arranged. The melting crucible 20 comprises a cup-shaped melting cavity 23. A bottom and/or or a sidewall of the melting cavity 23 is cladded by or provided with a thermal insulation 27. The thermal insulation 27 and/or the melting cavity 23 are thermally coupled with a heating 25 by way of which the content inside the melting cavity 23 can be heated and thus melted.

The receptacle 26 of the carrier 24 may comprise a bottom 22 on which the melting crucible 20 is positioned and supported. The entire carrier 24 may be arranged on a scale 48 in order to measure the weight of the entire melting crucible 20. Since the weight of the empty melting crucible 20 is constant a weight measurement of the melting crucible 20 with evaporation material 12 therein is directly indicative of the total weight and hence of the mass of the evaporation material 12.

The liquid level detector 81 may be installed or fixed to the carrier 24. In this way the position of the liquid level detector 81 relative to the melting crucible 20 and hence relative to the sidewall 21 is and remains constant. In other examples the liquid level detector 81 may be fixed to a base or to the ground 1. Here, the liquid level detector 81 may be operable to determined and/or to quantitatively measure an absolute level or height of the surface of the molten evaporation material 12 contained inside the melting cavity 23.

The liquid level detector 81 may comprise a distance meter 82 by way of which a distance between the surface of the molten evaporation material 12 and hence the fill level 28 relative to the sidewall 21 can be precisely measured. In some examples the liquid level detector 81 comprises a light source and a light detector to measure a distance between the liquid level detector and a surface of the molten evaporation material 12 in a reflection geometry. In some examples the liquid level detector comprises a laser-based distance measuring device.

In the presently illustrated example, wherein the measuring arrangement 80 comprises a both, a liquid level detector 81 and a scale 84, the amount or mass and hence the fill level 28 of molten evaporation material 12 inside the melting cavity 23 can be quantitatively determined or measured in a redundant way. By way of a redundant, i.e. twofold measurement of the fill level 28 in the melting cavity 23 the precision and reliability of a respective quantitative measurement can be improved. In addition, the measurement or determination of the fill level becomes rather failure safe.

The scale 84 as well as the liquid level detector 81 are coupled with the controller 90 in a signal transferring manner. Both, the scale 84 and the liquid detector 81 are configured to generate electrical measurement signals to be processed by the controller 90 in order to quantitatively determine the fill level 28 of molten evaporation material 12 inside the melting cavity 23.

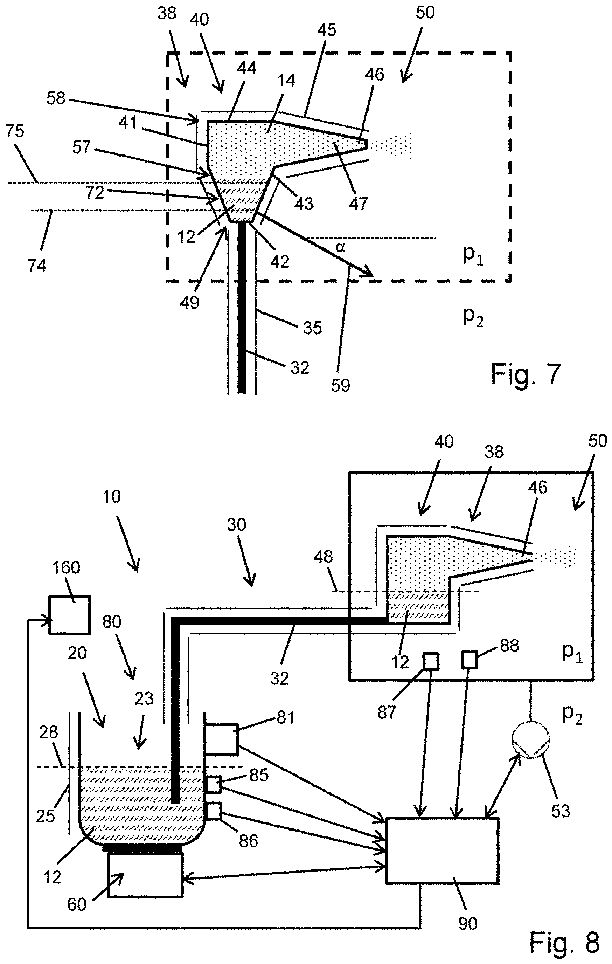

The measuring arrangement 80 may further comprise at least one of a temperature sensor 86 and a pressure sensor 85 as illustrated in Fig. 8. By way of a temperature sensor 86 the temperature of the molten evaporation material 12 inside the melting cavity 23 can be determined. Having knowledge of the weight of the molten evaporation material 12 inside the melting cavity 23 the fill level 28 can be precisely determined when taking into account the temperature dependency of the density of the evaporation material 12. Of course, the inner geometry of the melting cavity 23 is known.

The temperature sensor 86 may comprise a pyrometer and may be hence configured to contactlessly determine a temperature of the molten evaporation material 12, e.g. by arranging the temperature sensor 86 above the molten evaporation material 12.

The controller 90 is further connected to a pressure sensor 87 and a temperature sensor 88 located inside the evaporation chamber 50 or coupled with the evaporation chamber 50. By way of the pressure sensor 87 the vacuum pressure p1 inside the evaporation chamber 50 or vacuum chamber 52 can be quantitatively measured. In addition, also the temperature inside the evaporation chamber 50 and/or inside the evaporator 38 can be determined and/or quantitatively measured. The temperature sensor 86 may be also implemented as a pyrometer. The pressure sensor 87 may be either separately arranged inside the vacuum chamber 52 or may be integrated into the vacuum pump 53.

By quantitatively measuring the fill level 28 of the melting crucible 20 and by having knowledge of the momentary environmental pressure p2 and the vacuum pressure p1 inside the evaporation chamber 50 and further by having knowledge of a difference in height between the melting crucible 20 and the evaporation crucible 40 the fill level 48 of the molten evaporation material 12 inside the evaporation crucible 40 can be derived by the controller 90.

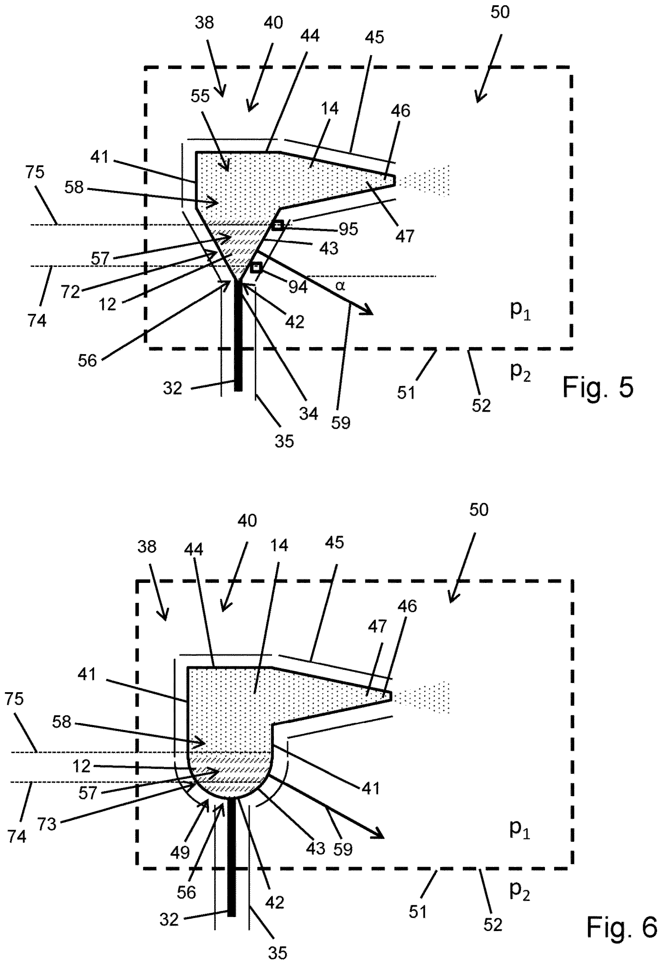

Of course, the evaporation units 10 and the measuring arrangement 80 are suitably calibrated. Initial calibration may be obtained by an initial filling of the evaporation crucible 40 with molten evaporation material 12 through the pipe 32 as indicated in Fig. 5. Here, the evaporation operation crucible 40 may be equipped with at least one fill level sensor 94, 95.

In the present example there are schematically illustrated two fill level sensors 94, 95 at different height or at different vertical positions. The fill level sensor 94 may define or correlate with a minimum fill level 74 of the evaporation crucible 40. The fill level sensor 95 may define or may coincide with a maximum fill level 75. The fill level sensors 94, 95 may be implemented as electrical contact-based fill level sensors. Each one of the fill level sensors 94, 95 may comprise two electrical contacts, which are electrically connected by the electrically conductive evaporation material 12. Hence, the fill level sensors 94, 95 may be operable to simply detect the presence of evaporation material 12 and the position of the respective fill level sensors 94, 95.

During operation of the evaporator 38 the fill level sensors 94, 95 may not be of any further use. They may be connected in a signal transferring manner with the controller 90 to generate an alert signal just in case that the fill level 48 should drop below the minimum for level 74 or if the fill level 48 should exceed the maximum fill level 75.

Once the evaporation unit 10 and hence the measuring arrangement 80 has been properly calibrated knowledge of the pressure difference between p1 and p2 and the absolute height of the fill level 28 e.g. relative to ground 1 is generally sufficient to derive the fill level 48 of the evaporation material 12 inside the evaporation cavity 55 on the basis of a quantitative measurement of the fill level 28 measured under atmospheric pressure.

By constantly measuring the environmental pressure p2 or atmospheric pressure the controller 90 may even take notice of eventual modifications or fluctuations of the environmental pressure. In order to compensate for such pressure changes and/or in order to compensate the variations of the fill level 28, e.g. due to supply of non-molten or molten evaporation material into the melting crucible 20 the controller 90 is operable to operate the liquid level adjuster 60, 160, thereby artificially modifying the fill level 28 relative to ground 1 or relative to the sidewall 21 of the melting crucible 20 to maintain the fill level 48 within a predefined range.

Alternatively, the controller 90 is operable to vary the immersion depth of the displacement body 161 in the melting cavity 23.

The controller 90 may further control the heating 25, 35, 45 by way of which the evaporation material 12 is heated either inside the melting cavity 23, inside the fluid connection 30 or pipe 32 or inside the evaporation crucible 40.

In Figs. 5-9 there are illustrated numerous examples of an evaporator 38. The evaporator 38 comprises the evaporation crucible 40. The evaporation crucible 40 confines an evaporation cavity 55. The evaporation cavity 55 comprises a bottom side inlet 56 and an outlet 46 adjacent or close to a top 44. The outlet 46 may comprise an outwardly protruding nozzle section 47, with a converging or narrowing diameter or cross-section towards its free end.

Insofar, the nozzle section 47 is operable to accelerate a flow or stream of gaseous evaporation material 14 towards the substrate 2.

The evaporation crucible 40 comprises a bottom section 49 through which there is provided a fluidic connection with the pipe 32. The bottom section may comprise a bottom 42. The bottom 42 may be planar shape as shown in Fig. 7 or may comprise a curved profile as shown in Fig. 6. In the example of Fig. 5 a lower sidewall section 43 of the sidewall 41 adjoining the bottom 42 is of a funnel shape and merges into the end section 34 of the pipe 32. Here, the bottom 42 may be formed by the lower end of the inclined lower sidewall section 43.

The evaporation cavity 55 is separated into a liquid storage section 57 an evaporation section 58, which is located above the liquid storage section 57. In the present terminology the liquid storage section 57 is that part of the evaporation cavity 55, which is entirely occupied by molten or liquid evaporation material 12. The evaporation section 58 is located above the liquid storage section. The size of the liquid storage section 58 may increase with a supply of molten evaporation material 12 into the evaporation cavity 55. Increase of the liquid storage section 57 is always at the expense of the evaporation section; and vice versa. Hence, the size of the liquid storage section 57 varies oppositely to the size of the evaporation section 58.

In use of the evaporator 38 and when heated to a suitable and operating temperature the molten evaporation material your 12 located in the liquid storage section 57 evaporates into the evaporation section 58. The molten evaporation material 12 transitions into evaporated and hence gaseous evaporation material 14.

An evaporation rate at which molten evaporation material 12 undergoes a phase transition into a gaseous state depends on the temperature inside the evaporation chamber 50 and hence inside the evaporation crucible 40 as well as on the vacuum pressure p1. The evaporation rate is further dependent on the available size of a surface of the of the liquid molten evaporation material 12 adjoining the evaporation section 58 from below.

In situations, wherein the evaporator 38 has been heated to a significant operating temperature and in case the evaporation process should be immediately stopped or interrupted the dissipation of respective heat is quite difficult and may require a comparatively long time interval. Here, regulating the evaporation rate only the temperature of the evaporator 38 or evaporation crucible 40 is quite tardy or sluggish.

In the examples of Figs. 5-9 the liquid storage section 57 defines a horizontal cross-sectional area of the evaporation cavity 55 that reduces in size towards the inlet 56 or bottom 42. The cross-sectional area may change gradually or in discrete steps with varying height. The surface of the horizontal cross-sectional area is particularly provided by a specific design of the sidewall 41, in particular by the geometry or design of the lower sidewall section 43.

With the example of Figs. 5 and 7 the lower sidewall section 43 comprises an inclined side wall section, wherein a distance of oppositely located sidewall portions reduces in horizontal direction the closer the respective sidewall portions get to the bottom 42 or inlet 56. As particularly indicated in Figs. 5 and 7, the minimum fill level 74 as well as the maximum for level 75 are located in the inclined or tilted lower sidewall section 43.

Insofar and by modifying the fill level 48 inside the evaporation cavity 55 the total size of an evaporating surface of the liquid molten evaporation material 12 inside the evaporation cavity 55 can be precisely varied. This provides and enables a rather precise control and adjustment of the evaporation rate while keeping the temperature of the evaporator 38 rather constant.

Generally and with the illustrated example a surface normal 59 of the lower sidewall section 43 extends at an angle at an angle $\alpha$ with respect to a horizontal line, wherein $\alpha > 0°$, $\alpha > 10°$, $\alpha > 15°$, $\alpha > 20°$, $\alpha > 30°$, $\alpha > 45°$ or wherein $\alpha > 60°$ and/or wherein $80° > \alpha > 10°$, $70°$

$> \alpha > 20°$, $60° > \alpha > 30°$, $50° > \alpha > 40°$, or wherein $\alpha$ is about $45°$.

In the example of Fig. 6 the lower side wall section 43 comprises a curved or concave structure. Here, the angle $\alpha$ between the surface normal 59 and a virtual horizontal line increases towards the bottom 42 and/or towards the inlet 56. In this way, there can be provided a well-defined nonlinear change of the evaporating surface of the liquid molten evaporation material 12 inside the evaporation cavity 55 with a variation of the fill level 48.

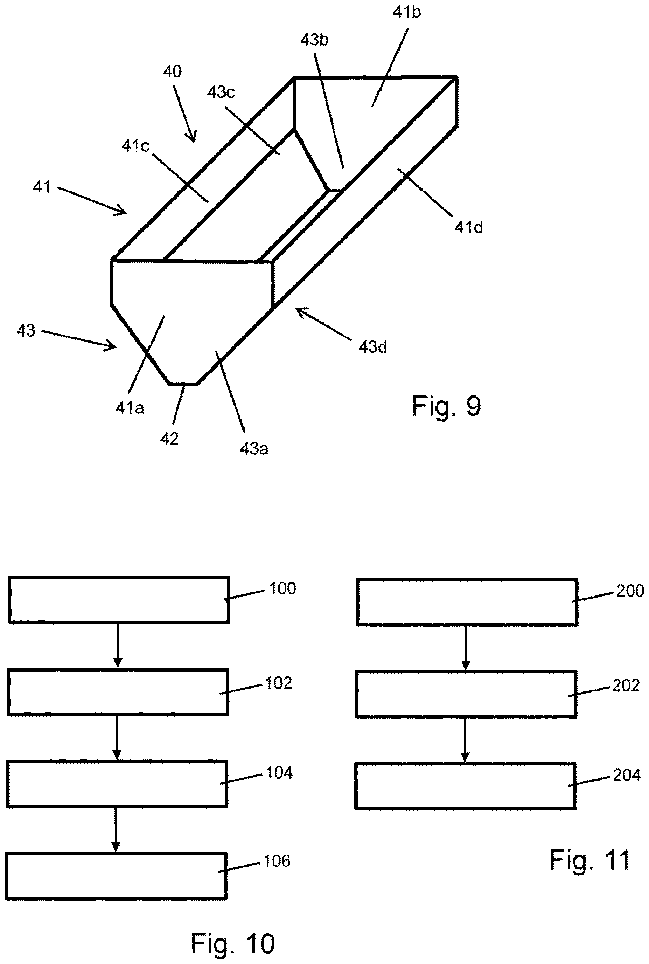

The transverse or horizontal cross-section of the evaporation crucible 40 may be of cylindrical geometry. It may be also of rectangular or oval geometry. In the perspective illustration of Fig. 9, which may correspond with the example of Fig. 7 the evaporation crucible 40 comprises a rectangular cross-section. Here, the sidewall 41 comprises a front face 41a opposite to a back face 41b. The front and back faces 41a, 41b, are connected at their respective opposite ends by longitudinally extending lateral sidewall portion 41c, 41d.

The lower sidewall section 43 comprises a funnel-type converging structure towards the bottom 42. Here, the respective lower portions 43c, 43d, of the lateral sidewall portions 41c, 41d are inclined towards each other and towards the bottom 42. The lower portion of the respective front and back faces 41a, 41b comprise somewhat triangular or trapezoidal structure.

The illustrated geometry is by no way limiting. It is generally conceivable that only one lateral sidewall portion 41c, 43c, 41d, 43d is inclined relative to an oppositely located sidewall portion.

In some examples, the front face 41a is aligned parallel to the back face 41b. In some examples, at least a portion of the front face 41a is inclined relative to the back face 41b. Here, a horizontal distance between the front face 41a and the back face 41b may decrease towards the bottom 42. Insofar and compared to examples, wherein only the sidewalls 41c, 41d are inclined relative to each other and wherein the front face 41a and the back face 41b extend substantially parallel to each other, there can be provided a higher degree of a size reduction of the horizontal cross-sectional area of the evaporation cavity with a decreasing height or level above the bottom 42.

The longitudinal extent of the lateral sidewall portion and hence the larger extent of the lateral sidewall portions 41c, 41d compared to the lateral or horizontal extent of the back and front faces 41a, 41b is beneficial to provide a rather elongated nozzle section 47, which might be beneficial to homogeneously distribute the evaporation material 14 over a comparatively large surface.

The flowchart according to Fig. 10 is illustrative of a method of deriving or determining a fill level of evaporation material inside the evaporation crucible 40. In a first step 100 there is quantitatively measured at least one of a fill level and a mass of molten evaporation material 12 inside the melting crucible 20 and hence outside the evaporation chamber 50. In a second step 102 the vacuum pressure p1 inside the evaporation chamber 50 is determined. In a subsequent step 104 or concurrently with step 102 there is also measured an environmental or atmospheric pressure p2.

From the pressure difference and by having knowledge of the geometry and/or of the position of the melting crucible 20 relative to the evaporation crucible 40 there is derived and/or calculated the fill level 48 of the molten evaporation material 12 inside the evaporation crucible 40 in step 106. In further optional steps there may be also taking into account the temperature of the molten evaporation material 12 inside the melting cavity 23 and/or inside the evaporation cavity 55 to increase precision of the determination of the fill level 48. Due to the temperature dependency of the density of the molten evaporation material 12 a temperature difference between the melting crucible 20 and the evaporation crucible 40 may cause a further offset between the fill level 48 relative to the fill level 28. By measuring the temperatures such effect can be compensated.

Furthermore and in subsequent steps or by way of a control loop of numerous of the above steps the controller 90 may be operable to modify, e.g. to artificially modify the fill level 28 or and/or the height the surface of the molten evaporation material 12 inside the melting crucible 23 by making use of the liquid level adjuster 60, 160. Hence, by raising or lowering the melting crucible 20 relative to ground 1 the fill level 48 of the stationary evaporation crucible 40 can be adjusted and controlled.

In a likewise manner and e.g. when the melting crucible 20 should be stationary arranged relative to the ground 1 the fill level 28 may be artificially modified or controlled by the liquid level adjuster 160, namely by modifying or adjusting an immersion depth of the displacement body 161 in the molten evaporation material 12.

The flowchart according to Fig. 11 is indicative of a further method of adjusting or controlling en evaporation rate of an operation unit 10. Specifically, the method makes use of the evaporation crucible 40 as particularly illustrated in Figs. 5, 6, 7, 8 or 9. There, the evaporation cavity 55 of the evaporation crucible 40 features a horizontal cross-sectional area of a sidewall that reduces towards the inlet 56 or bottom 42 of the evaporation crucible 40. Here and in a first step 200 the evaporation crucible 40 is filled with an amount of molten evaporation material 12, e.g. through the fluid connection 30.

An initial fill level 48 of the molten evaporation material is typically below a maximum fill level 75 and above a minimum level 74. Thereafter or concurrently with initially filling the evaporation crucible 40 in step 202 the temperature of the evaporation cavity 55 is raised or kept at an evaporation temperature at which a substantial portion of the molten evaporation material 12 evaporates in accordance to a first evaporation rate. In step 204 and e.g. based on the above described indirect measurement of the fill level 48 of the molten evaporation material 12 inside the evaporation crucible the fill level 48 inside the evaporation crucible 40 may be reduced in step 204 to vary, i.e. to reduce the surface of the surface of the molten evaporation material 12 adjacent to the evaporation section 58 of the evaporation cavity 55.

By varying, e.g. by increasing or decreasing the size of the evaporation surface of the molten evaporation material 12 inside the evaporation crucible 40, the evaporation rate at which liquefied or molten evaporation material 12 transitions into an evaporated state and turns into evaporated material 14 reduces in accordance to the size reduction of the surface of the molten material incurred with a decreasing of the fill level 48. In the same way, the evaporation rate could be also increased, e.g. by increasing the fill level 48 of the evaporation cavity 55.

Reference Numbers

[0132]

| | |
|---|---|
| 1 | ground |
| 2 | substrate |
| 5 | coating arrangement |
| 10 | evaporation unit |
| 12 | molten material |
| 14 | evaporated material |
| 18 | melting unit |
| 20 | melting crucible |
| 21 | side wall |
| 22 | bottom |
| 23 | melting cavity |
| 24 | carrier |
| 25 | heating |
| 26 | receptacle |
| 27 | insulation |
| 28 | fill level |
| 30 | fluid connection |
| 32 | pipe |
| 33 | end section |
| 34 | end section |
| 35 | heating |
| 36 | flexible portion |
| 38 | evaporator |
| 40 | evaporation crucible |
| 41 | sidewall |
| 42 | bottom |
| 43 | sidewall section |
| 44 | top |
| 45 | heating |
| 46 | outlet |
| 47 | nozzle section |
| 48 | fill level |
| 49 | bottom section |
| 50 | evaporation chamber |
| 51 | chamber wall |
| 52 | vacuum chamber |
| 53 | vacuum pump |

| 55 | evaporation cavity |
| 56 | inlet |
| 57 | liquid storage section |
| 58 | evaporation section |
| 59 | surface normal |
| 60 | liquid level adjuster |
| 61 | lifting device |
| 62 | scissor lift |
| 70 | feeding unit |
| 72 | funnel portion |
| 73 | curved portion |
| 74 | minimum fill level |
| 75 | maximum fill level |
| 80 | measuring arrangement |
| 81 | liquid level detector |
| 82 | distance meter |
| 84 | scale |
| 85 | pressure sensor |
| 86 | temperature sensor |
| 87 | pressure sensor |
| 88 | temperature sensor |
| 90 | controller |
| 94 | fill level sensor |
| 95 | fill level sensor |
| 160 | liquid level adjuster |
| 161 | displacement body |
| 162 | connector |
| 163 | drive |

**Claims**

1. An evaporation unit (10) for evaporating a metallic evaporation material, the evaporation unit (10) comprising:

- an evaporation crucible (40) inside an evaporation chamber (50),
- a melting crucible (20) outside the evaporation chamber (50) and fluidically connected with the evaporation crucible (40), the melting crucible (20) comprising a melting cavity (23) to melt the metallic evaporation material, to store and/or to heat molten evaporation material (12),
- a measuring arrangement (80) coupled to the melting crucible (20) and operable to quantitatively measure at least one of a fill level (28) of molten evaporation material (12) in the melting cavity (23) and a mass of molten evaporation material (12) in the melting crucible (20), the measuring unit (80) being further operable to generate a measurement signal being indicative of at least one of the fill level (28) and the mass of molten evaporation material (12),
- a controller (90) connected to the measuring arrangement (80) and operable to derive a fill level (48) of molten evaporation material (12) inside the evaporation crucible (40) on the basis of the measurement signal received from the measuring arrangement (80).

2. The evaporation unit (10) according to claim 1, wherein the measuring arrangement (80) comprises at least one of a pressure sensor (85, 87) and a temperature sensor (86, 88), wherein the pressure sensor (85, 87) is operable to measure at least one of an environmental pressure (P2) inside or around the melting cavity (23) and a vacuum pressure (P1) inside the evaporation chamber (50) and wherein the temperature sensor (86, 88) is operable to measure a temperature of the molten evaporation material (12) at least inside one of the melting cavity (23) and the evaporation crucible (40).

3. The evaporation unit (10) according to claim 2, wherein the controller (90) is operable to derive the fill level (48) of molten evaporation material (12) inside the evaporation crucible (40) by taking further into account at least one of the environmental pressure (P2) inside or around the melting cavity (23), the vacuum pressure (P1) inside the evaporation chamber (50), the temperature of the molten evaporation material (12) inside the melting cavity (23) and the temperature of the molten evaporation material (12) inside the evaporation crucible (40).

4. The evaporation unit (10) according to any one of the preceding claims, further comprising a liquid level adjuster (60; 160) coupled with the melting crucible (20) and operable to vary a level of the molten evaporation material (12) inside the melting cavity (23) with respect to a ground (1) and/or with respect to a sidewall (21) of the melting crucible (20).

5. The evaporation unit (10) according to any one of the preceding claims, wherein a fill level of molten evaporation material (12) inside the evaporation crucible (40) is adjustable by varying the level or height of the molten evaporation material (12) in the melting crucible (20).

6. The evaporation unit (10) according to claim 4 or 5, wherein the liquid level adjuster (60; 160) is coupled to the controller (90) and wherein the controller (90) is operable to control operation of the liquid level adjuster (60; 160) to keep the fill level (48) of molten evaporation material (12) inside the evaporation crucible (40) in a predefined range.

7. The evaporation unit (10) according to claim 4 to 6, wherein the liquid level adjuster (60) comprises a lifting device (61) supporting the melting crucible (20) and operable to modify and/or to adjust a height of the melting crucible (20) relative to the ground (1).

8. The evaporation unit (10) according to any one of the preceding claims 4-7, wherein the liquid level adjuster (160) comprises a displacement body (161) variably immersible into the molten evaporation material (12) inside the melting crucible (20) to thereby vary a level of the molten evaporation material (12) inside the melting cavity (23) with respect to the sidewall (21) of the evaporation crucible (20).

9. The evaporation unit (10) according to any one of the preceding claims, wherein the melting crucible (20) and the evaporation crucible (40) are fluidically connected via a heated fluid connection (30).

10. The evaporation unit (10) according to any one of the preceding claims, further comprising a feeding unit (70) operable to supply solid or molten evaporation material (12) into the melting crucible (20).

11. The evaporation unit (10) according to claim 10, wherein the feeding unit (70) is coupled to the controller (90) and wherein the controller (90) is operable to control a supply of solid or molten evaporation material (12) into the melting crucible (20).

12. The evaporation unit (10) according to any one of the preceding claims, wherein the melting crucible (20) is exposed to atmospheric pressure.

13. The evaporation unit (10) according to any one of the preceding claims, wherein the measuring arrangement (80) comprises at least one of a fill level sensor and a scale (84) coupled to the melting crucible (20), wherein the fill level sensor (81) is operable to measure the fill level of molten evaporation material (12) inside the melting crucible (20) and wherein the scale (84) is operable to measure at least one of a weight of the melting crucible (20) and the molten evaporation material (12) inside the melting crucible (20).

14. A coating arrangement (5) for coating a substrate (2) with a metallic material through vapor deposition, the coating arrangement (5) comprising:

- an evaporation chamber (50) to receive the substrate (2), and
- an evaporation unit (10) according to any one of the preceding claims.

15. A method of deriving or determining a fill level (48) of molten evaporation material (12) inside an evaporation crucible (40) located inside an evaporation chamber (50), wherein the evaporation crucible (40) is fluidically connected with a melting crucible (20) outside the evaporation chamber (50) and wherein the melting crucible (20) is configured to store and/or to heat molten evaporation material (12), the method comprises the steps of:

- measuring at least one of a fill level (28) and a mass of molten evaporation material (12) inside the melting crucible (20) outside the evaporation chamber (50) and
- deriving or determining the fill level (48) of molten evaporation material (12) inside the evaporation crucible (40) on the basis of at least one of the fill level (28) and the mass of molten evaporation material (12) inside the melting crucible (20).

Fig. 1

Fig. 2

Fig. 3

Fig. 4

Fig. 5

Fig. 6

Fig. 7

Fig. 8

Fig. 9

Fig. 10

Fig. 11

Europäisches
Patentamt

European
Patent Office

Office européen
des brevets

## EUROPEAN SEARCH REPORT

Application Number

EP 23 16 7265

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP S63 199868 A (MITSUBISHI HEAVY IND LTD; NISSHIN STEEL CO LTD) 18 August 1988 (1988-08-18) * figure 1 * * the whole document * | 1-15 | INV. C23C14/24 C23C14/54 |
| X | KR 101 639 811 B1 (POSCO [KR]) 15 July 2016 (2016-07-15) * paragraph [0027] – paragraph [0078]; figure 1 * | 1,4-6,9, 12-15 | |

TECHNICAL FIELDS SEARCHED (IPC)

C23C

The present search report has been drawn up for all claims

| Place of search | Date of completion of the search | Examiner |
|---|---|---|
| The Hague | 24 September 2023 | Engelen, Karen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 7265

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2023

| Patent document cited in search report | Publication date | Patent family member(s) | Publication date |
|---|---|---|---|
| JP S63199868 A | 18-08-1988 | NONE | |
| KR 101639811 B1 | 15-07-2016 | NONE | |

EPO FORM P0459

For more details about this annex : see Official Journal of the European Patent Office, No. 12/82

**EP 4 446 458 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3812481 A1